(19) Europäisches Patentamt
European Patent Office
Office européen des brevets

(11) **EP 1 308 026 B1**

(12) **EUROPÄISCHE PATENTSCHRIFT**

(45) Veröffentlichungstag und Bekanntmachung des Hinweises auf die Patenterteilung:
**19.01.2005  Patentblatt 2005/03**

(51) Int Cl.$^7$: **H04M 19/02**, H04M 19/00, H04L 27/00

(21) Anmeldenummer: **01971786.7**

(22) Anmeldetag: **26.07.2001**

(86) Internationale Anmeldenummer:
**PCT/EP2001/008668**

(87) Internationale Veröffentlichungsnummer:
**WO 2002/013371 (14.02.2002 Gazette 2002/07)**

(54) **TREIBERSCHALTUNG FÜR TEILNEHMERENDGERÄTE**

DRIVER CIRCUIT FOR SUBSCRIBER TERMINALS

CIRCUIT D'ATTAQUE POUR TERMINAUX D'ABONNES

(84) Benannte Vertragsstaaten:
**FR GB**

(30) Priorität: **07.08.2000  DE 10038374**

(43) Veröffentlichungstag der Anmeldung:
**07.05.2003  Patentblatt 2003/19**

(73) Patentinhaber: **Infineon Technologies AG**
**81669 München (DE)**

(72) Erfinder: **FERIANZ, Thomas**
**A-9555 Glanegg (AT)**

(74) Vertreter: **Reinhard - Skuhra - Weise & Partner**
**Postfach 44 01 51**
**80750 München (DE)**

(56) Entgegenhaltungen:
**EP-A- 0 994 610**

- **STEFFES M ET AL: "OPTIMIZING PERFORMANCE IN AN XDSL LINE DRIVER" ELECTRONIC DESIGN, PENTON PUBLISHING, CLEVELAND, OH, US, Bd. 47, Nr. 8, 19. April 1999 (1999-04-19), Seite 44,46,48,52,54,56,58 XP000893613 ISSN: 0013-4872**
- **JOHNS D A ET AL: "Integrated circuits for data transmission over twisted-pair channels" CUSTOM INTEGRATED CIRCUITS CONFERENCE, 1996., PROCEEDINGS OF THE IEEE 1996 SAN DIEGO, CA, USA 5-8 MAY 1996, NEW YORK, NY, USA,IEEE, US, 5. Mai 1996 (1996-05-05), Seiten 5-12, XP010167404 ISBN: 0-7803-3117-6**
- **MOYAL M ET AL: "A 25-KFT, 768-KB/S CMOS ANALOG FRONT END FOR MULTIPLE-BIT-RATE DSL TRANSCEIVER" IEEE JOURNAL OF SOLID-STATE CIRCUITS, IEEE INC. NEW YORK, US, Bd. 34, Nr. 12, Dezember 1999 (1999-12), Seiten 1961-1972, XP000932526 ISSN: 0018-9200**

**Beschreibung**

Die Erfindung betrifft eine Treiberschaltung für Teilnehmerendgeräte mit einer sehr geringen Verlustleistung.

Aus der DE 19740137 A1 ist ein Verfahren und eine Schaltungsanordnung zur Rufwechselspannungserzeugung für elektronische Teilnehmerschaltungen bekannt. Dabei wird die Betriebsspannung eines Leistungsverstärkers derart geregelt, dass die Betriebsspannung in bestimmten zeitlichen Abschnitten den zeitlichen Verlauf einer verstärkten Rufwechselspannung folgt.

Die DE 19858963 A1 beschreibt einen Audiosignalverstärker mit einer steuerbaren Spannungsversorgung für eine Verstärkerstufe und mit einer Analyseeinheit zur Analyse des zu verstärkenden Audiosignals. Der Audiosignalverstärker enthält ferner eine Steuereinheit zur Steuerung der Spannungsversorgung in Abhängigkeit von dem analysierten Audiosignal und eine Verzögerungseinheit 3, die das eingehende Audiosignal relativ zu dem der Analyseeinheit zugeführten Audiosignal verzögert.

Bei herkömmlichen Kommunikationssystemen werden häufig Gleichspannungen bzw. niederfrequente Signale sowie hochfrequente Signale über eine Signalleitung bzw. einen Übertragungskanal übertragen. Bei den Gleichspannungen handelt es sich beispielsweise um Versorgungsspannungen für Teilnehmerendgeräte. Die niederfrequenten Signale sind beispielsweise analoge Sprachsignale oder Ruftonsignale für Telefone. Die durch die Kommunikationssysteme zu übertragenden hochfrequenten Signale sind meist Datensignale, wie beispielsweise xDSL-Datensignale.

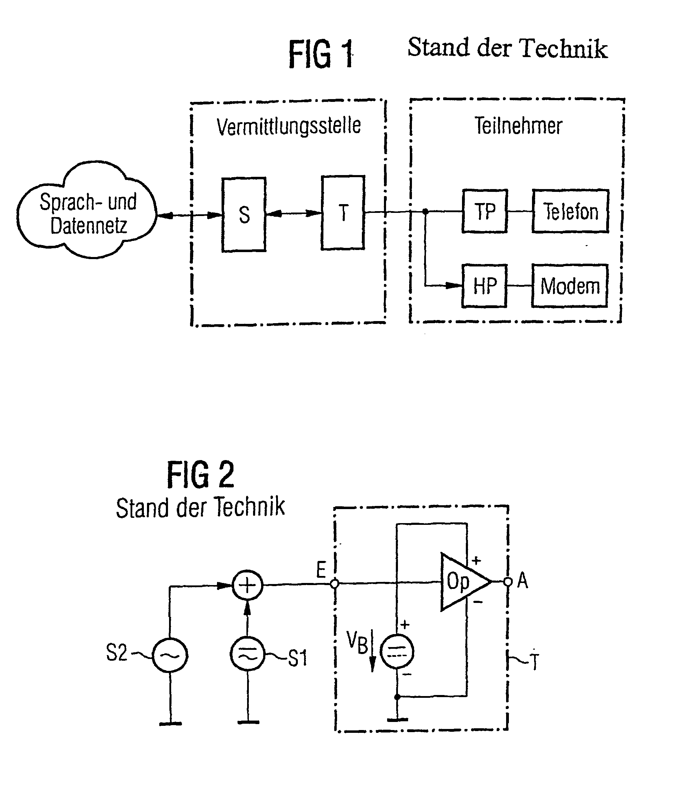

Figur 1 zeigt schematisch ein Beispiel für ein Kommunikationssystem bei dem niederfrequente und hochfrequente Signale über die gleiche Leitung übertragen werden. Von einem Sprach- und Datennetz werden niederfrequente Sprachsignale und hochfrequente Datensignale einer Vermittlungsstelle zugeführt, die über eine Schalteinrichtung S, beispielsweise einer Multiplexerschaltung, verfügt. Die Schalteinrichtung S ist mit einer Treiberschaltung T für einen Teilnehmer verbunden. Jeder mit der Vermittlungsstelle verbundene Teilnehmer verfügt dabei über eine eigene Treiberschaltung T. Von der Treiberschaltung T gelangen die Sprach- und Datensignale beispielsweise zu einem sogenannten Splitter, der aus zwei Filtern, nämlich einem Hochpassfilter HP und einem Tiefpassfilter TP, besteht. An dem Tiefpassfilter TP ist ein Telefon angeschlossen, das die niederfrequenten Sprachsignale empfängt. An dem Hochpassfilter HP ist ein Datenmodem angeschlossen, das die hochfrequenten Datensignale demoduliert bzw. moduliert. Die von der Treiberschaltung T an den Teilnehmer übertragene Gleichspannungen, die beispielsweise der Spannungsversorgung des Telefons dienen, sowie der niederfrequente Rufton besitzen in der Regel große Signalamplituten von mehr als 100 Volt. Dies macht eine sehr hohe Versorgungsspannung für die Treiberschaltung T notwendig. Die hochfrequenten Signalströme, die beispielsweise der Datenübertragung dienen, weisen eine deutlich geringere Signalamplitute auf. Aufgrund der niederohmigeren Lastimpedanz rufen jedoch die hochfrequenten Signalströme große Versorgungsströme hervor, die der Versorgungsspannung der Treiberschaltung T entnommen werden.

Figur 2 zeigt eine Treiberschaltung T nach dem Stand der Technik. Die Treiberschaltung T enthält einen Operationsverstärker OP der über zwei Versorgungsspannungsleitungen durch eine zugehörige Versorgungsspannungsquelle $V_B$ mit Spannung versorgt wird. An dem Eingang E der Treiberschaltung T sind eine niederfrequente Signalquelle S1 und eine hochfrequente Signalquelle S2 angeschlossen, deren Signalströme überlagert sind. Die Überlagerung der verschiedenen Signalströme bzw. Signalanteile ist in Figur 2 durch ein Summierglied angedeutet. Die niederfrequente Spannungsquelle S1 liefert die Gleichspannungen zur Versorgung der Endgeräte sowie niederfrequente Signale, insbesondere niederfrequente Sprachsignale. Die hochfrequente Signalquelle S2 gibt hochfrequente Datensignale mit einer relativ geringen Signalamplitude ab. Am Ausgang A der Treiberschaltung T steht das gesamte Signalspektrum niederohmig zum Treiben der am Ausgang angeschlossenen Endgeräte zur Verfügung.

Die Versorgungsspannung $V_B$ für die Treiberschaltung T wird in der Regel durch ein angeschlossenes Netzteil geliefert.

Der Nachteil der in Figur 2 dargestellten Treiberstufe T nach dem Stand der Technik besteht darin, dass die Versorgungsspannung $V_B$ derart hoch gewählt werden muss, dass die maximalen Signalamplituden der beiden Signalquellen S1 und S2 im Operationsverstärker OP nicht begrenzt werden.

Die erforderliche Versorgungsspannung $V_B$ für den Operationsverstärker OP innerhalb der Treiberstufe T lässt sich aus folgender Beziehung errechnen:

$$V_B = \hat{S}_1 + \hat{S}_2 + V_{Drop}$$

wobei

$\hat{S}_1$.. Scheitelwert der nierderfrequenten Signalströme,
$\hat{S}_2$.. Scheitelwert der hochfrequenten Signalströme,
$V_{Drop}$.. konstruktionsbedingter Spannungsabfall in der Treiberschaltung.

Die durch den Laststrom bedingte Verlustleistung $P_V$ der Treiberschaltung T ergibt sich aus:

$$P_V = P_G - P_L = V_B \cdot F_2 \cdot i_{1,2} - P_L$$

wobei

| | |
|---|---|
| $P_V$ | laststrombedingte Verlustleistung in der Treiberschaltung T, |
| $P_G$ | laststrombedingte Gesamtleistungsaufnahme der Treiberschaltung T, |
| $P_L$ | an die Last abgegebene Leistung, |
| $V_B$ | Versorgungsspannung der Treiberschaltung T, |
| $i_{1,2}$ | Effektivwert des gesamten Signalstromes, |
| $F_2$ | der Formfaktor ist, d.h. das signalformabhängige Verhältnis zwischen Gleichrichtwert und Effektivwert eines Signals. |

Die Verlustleistung der Treiberschaltung T steigt, wie man der Gleichung entnehmen kann, mit zunehmender Versorgungsspannung $V_B$ der Treiberschaltung an. Da die Versorgungsspannung $V_B$ der Treiberschaltung T nach dem Stand der Technik größer als die Summe der beiden Scheitelwerte $S_1$, $S_2$ der niederfrequenten und hochfrequenten Signalströme ist, ist die notwendige Versorgungsspannung $V_B$ der Treiberschaltung T und somit die Verlustleistung $P_V$ der Treiberschaltung T sehr hoch. Die hervorgerufene Verlustleistung $P_V$ ist bei der herkömmlichen Treiberschaltung T, wie sie in Figur 2 gezeigt ist, derart hoch, dass es bisher nicht möglich war, integrierte Treiberschaltungen für Full-Rate-ADSL in Verbindung mit einer analogen Sprachsignalübertragung ohne ein aufwendiges Gehäuse mit sehr großen Kühlkörpern zu realisieren.

EP 0994610 offenbart beispielsweise eine Treiberschaltung für DSL nach dem Stand der Technik.

Es ist daher die Aufgabe der vorliegenden Erfindung ein Treiberschaltung zur Übertragung von niederfrequenten und hochfrequenten Signalströmen an Teilnehmerendgeräte zu schaffen, deren Verlustleistung minimal ist.

Diese Aufgabe wird erfindungsgemäß durch eine Treiberschaltung an Teilnehmerendgeräte mit den im Patentanspruch 1 angegebenen Merkmalen gelöst.

Die Erfindung schafft eine Treiberschaltung für mindestens ein Teilnehmerendgerät mit einem ersten Treiber zur Leistungsverstärkung eines anliegenden Gleichspannungssignals für die Leistungsversorgung des Teilnehmerendgeräts, wobei der erste Treiber durch eine erste Versorgungsspannung ($V_1$) versorgt wird, und mit einem dem ersten Treiber nachgeschalteten zweiten Treiber zum Aufmodulieren von hochfrequenten Signalströmen auf das leistungsverstärkte Gleichspannungssignal.

Dem ersten Treiber ist vorzugsweise ein Tiefpassfilter nachgeschaltet.

Dieser Tiefpassfilter ist bei einer bevorzugten Ausführungsform ein Tiefpassfilter erster Ordnung.

Bei dem Tiefpassfilter erster Ordnung handelt es sich vorzugsweise um einen RC-Tiefpassfilter, das einen Widerstand und einen Kondensator enthält.

Dabei ist der Widerstand vorzugsweise ein passives Bauelement.

Bei einer alternativen Ausführungsform ist der Widerstand als eine aktive Impedanz ausgeführt.

Die Grenzfrequenz des Tiefpassfilters ist vorzugsweise einstellbar.

Dies bietet den Vorteil, dass die Treiberschaltung für verschiedene Kommunikationsstandards, beispielsweise verschieden DSL-Standards einsetzbar ist.

Die Grenzfrequenz des Tiefpassfilters liegt vorzugsweise zwischen der oberen Grenzfrequenz der niederfrequenten Signalströme und der unteren Grenzfrequenz der hochfrequenten Signalströme.

Bei einer bevorzugten Ausführungsform der erfindungsgemäßen Treiberschaltung ist eine erste Spannungsquelle vorgesehen, die zur Erzeugung der ersten Versorgungsspannung ein festes Bezugspotential aufweist.

Dabei ist das Bezugspotential vorzugsweise das Massepotential.

Bei einer weiteren bevorzugten Ausführungsform der erfindungsgemäßen Treiberschaltung ist eine zweite Spannungsquelle zur Erzeugung der zweiten Versorgungsspannung vorgesehen, die bezugspotentialfrei an den Ausgang des Tiefpassfilters angeschlossen ist.

Die von der zweiten Spannungsquelle abgegebene zweite Versorgungsspannung für den zweiten Treiber ist bei einer bevorzugten Ausführungsform der erfindungsgemäßen Treiberschaltung wesentlich niedriger als die von der ersten Spannungsquelle abgegebene erste Versorgungsspannung für den ersten Treiber.

Der erste Treiber ist vorzugsweise ein Operationsverstärker.

Bei einer alternativen Ausführungsform ist der erste Treiber ein AC/DC-Wandler mit Stromrückspeisung.

Bei einer weiteren alternativen Ausführungsform ist der erste Treiber ein DC/DC-Wandler mit Stromrückspeisung.

Der zweite Treiber ist vorzugsweise ein Operationsverstärker mit einer linearen Verstärkung.

Bei einer weiteren bevorzugten Ausführungsform der erfindungsgemäßen Treiberschaltung ist an einen Signaleingang des ersten Treibers eine niederfrequente Signalquelle anschließbar.

Bei einer weiteren bevorzugten Ausführungsform ist ein Signaleingang des zweiten Treibers mit dem Ausgang einer Summierschaltung verbunden.

Dabei ist die niederfrequente Signalquelle vorzugsweise an einen ersten Eingang der Summierschaltung anschließbar.

Die hochfrequente Signalquelle ist vorzugsweise an einen zweiten Eingang der Summierschaltung anschließbar.

Bei einer besonders bevorzugten Ausführungsform der erfindungsgemäßen Treiberschaltung ist an einen dritten Eingang der Summierschaltung eine dritte Versorgungsspannungsquelle zur Signalpegelerhöhung an dem Signaleingang des zweiten Treibers angeschlossen.

Die dritte Versorgungsspannungsquelle gibt dabei vorzugsweise eine Versorgungsspannung ab, die halb so hoch ist wie die von der zweiten Versorgungsspannungsquelle abgegebene zweite Versorgungsspannung.

An einen Signalausgang des zweiten Treibers ist vorzugsweise das Teilnehmerendgerät anschließbar.

Die niederfrequenten Signalströme, die durch den ersten Treiber verstärkt werden, umfassen vorzugsweise Gleichströme zur Versorgung des Teilnehmerendgerätes, Sprachsignalströme sowie Ruftonströme.

Die hochfrequenten Signalströme, die durch den zweiten Treiber verstärkt werden, umfassen vorzugsweise hochfrequente Datensignalströme.

Diese hochfrequenten Datensignalströme sind vorzugsweise xDSL-Datensignalströme.

Bei einer besonders bevorzugten Ausführungsform der erfindungsgemäßen Treiberschaltung ist diese Treiberschaltung differentiell aufgebaut.

Dabei weist der zweite Treiber zwei differentiell zueinander verschaltete Operationsverstärker auf, die jeweils durch eine bezugspotentialfreie Versorgungsspannung versorgt werden.

Die beiden bezugspotentialfreien Versorgungsspannungen werden dabei vorzugsweise jeweils durch Sperrwandler erzeugt, deren Sekundärwicklung nicht geerdet ist.

Im weiteren werden bevorzugte Ausführungsformen der erfindungsgemäßen Treiberschaltung unter Bezugnahme auf die beigefügten Figuren zur Erläuterung erfindungswesentlicher Merkmale beschrieben.

Es zeigen:

Figur 1     den Aufbau eines Kommunikationssystems zur Übertragung von hochfrequenten und niederfrequenten Signalen auf einer Leitung nach dem Stand der Technik;

Figur 2     eine Treiberschaltung T nach dem Stand der Technik;

Figur 3     eine erste Ausführungsform der erfindungsgemäßen Treiberschaltung,

Figur 4     eine zweite Ausführungsform der erfindungsgemäßen Treiberschaltung.

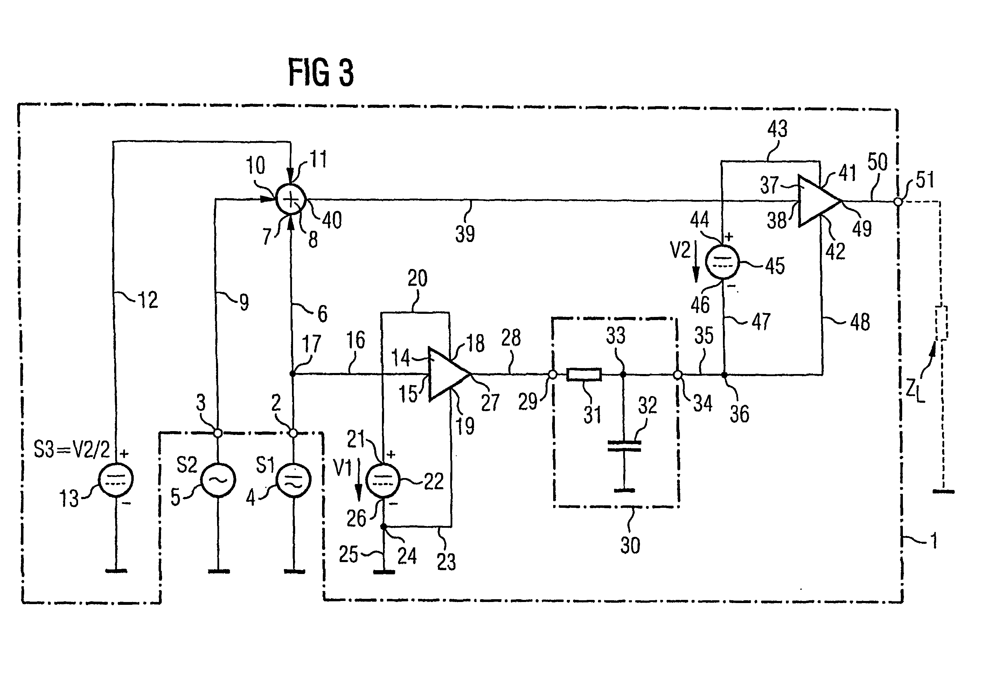

Die Treiberschaltung 1 für Teilnehmerendgeräte gemäß der Erfindung besitzt bei der in Figur 3 gezeigten Ausführungsform zwei Signaleingänge 2,3 zum Anschluss einer niederfrequenten Signalquelle 4 und einer hochfrequenten Signalquelle 5. Die von der niederfrequenten Signalquelle S1 abgegebenen niederfrequenten Signalströme gelangen von dem Signaleingang 2 über eine Leitung 6 zu einem ersten Eingang 7 einer Summierschaltung 8. Die von der hochfrequenten Signalquelle 5 abgegebenen hochfrequenten Signalströme werden über eine Leitung 9 an einen zweiten Eingang 10 der Summierschaltung 8 angelegt. Die Summierschaltung 8 besitzt einen dritten Eingang 11, an dem über eine Leitung 12 eine dritte Spannungsquelle 13 angeschlossen ist. Die Aufsummation bzw. Überlagerung der hochfrequenten und niederfrequenten Signalströme, die von der niederfrequenten Signalstromquelle 4, der hochfrequenten Signalstromquelle 5 abgegeben werden, kann auch außerhalb der Treiberschaltung 1 erfolgen.

Die Treiberschaltung 1 enthält einen ersten Treiber 14 für die niederfrequenten Signalströme, dessen Eingang 15 über eine interne Leitung 16 an einem Abzweigungsknoten 17 mit der Leitung 6 verbunden ist. Der erste Treiber 14 besitzt zwei Versorgungsspannungsanschlüsse 18,19 zum Anlegen einer ersten Versorgungsspannung $V_1$. Der erste Versorgungsspannungsanschluss 18 des Treibers 14 ist über eine Versorgungsspannungsleitung 20 an einen ersten Anschluss 21 einer Versorgungsspannungsquelle 22 angeschlossen. Der zweite Versorgungsspannungsanschluss 19 des Treibers 14 ist über eine Leitung 23 an einen Verzweigungsknoten 24 angeschlossen. Der Verzweigungsknoten 24 liegt auf einer Leitung 25, die einen zweiten Anschluss 26 der Versorgungsspannungsquelle 22 an das Bezugspotential Masse anlegt. Der Signalausgang 27 des Treibers 14 ist über eine Leitung 28 an einen Eingangsanschluss 29 eines Tiefpassfilters 30 angeschlossen. Das Tiefpassfilter 30 enthält einen Widerstand 31 und einen Kondensator 32. Der Kondensator 32 des Tiefpassfilters 30 ist an einem Knoten 33 mit dem Widerstand 31 verbunden und ist an seinem gegenüberliegenden Anschluss an das Bezugspotential Masse geschaltet.

Bei dem im Figur 3 dargestellten Tiefpassfilter 30 handelt es sich um ein Tiefpassfilter erster Ordnung, das schaltungstechnisch mit sehr geringem Aufwand herstellbar ist. Der Widerstand 31 entweder ein passives Bauelement oder eine aktive Impedanz, die durch Impedanzsynthese realisiert wird. Es kann sich dabei beispielsweise um eine aktive Ausgangsimpedanz des Treibers 14 handeln. Die Grenzfrequenz $f_g$ des Tiefpassfilters 30 ist vorzugsweise einstellbar.

Hierzu wird vorzugsweise der Widerstand des Widerstandes 31 oder die Kapazität des Kondensators 32 verändert. Bei einer alternativen Ausführungsform ist der Widerstandswert des Widerstandes 31 programmierbar. Die Grenzfrequenz $f_g$ des Tiefpassfilters 30 liegt zwischen der oberen Grenzfrequenz der niederfrequenten Signalströme, beispielsweise 4. kHz für Sprachsignale, und der unteren Grenzfrequenz der hochfrequenten Signalströme, beispielsweise 138 kHz für DSL-Datensignalströme. Ein Ausgang 34 des Tiefpassfilters 30 ist über eine Leitung 35 mit einem Knoten 36 verbunden.

Die Treiberschaltung 1 gemäß der Erfindung enthält einen zweiten Treiber 37 dessen Signaleingang 38 über eine Leitung 39 an den Ausgang 40 der Summierschaltung 8 angeschlossen ist. Der zweite Treiber 37 weist einen ersten Versorgungsspannungsanschluss 41 und einen zweiten Versorgungsspannungsanschluss 42 auf. Der erste Versorgungsspannungsanschluss 41 des Treibers 37 ist über eine Versorgungsspannungsleitung 43 mit einem ersten Anschluss 44 einer Versorgungsspannungsquelle 45 verbunden. Die Versorgungsspannungsquelle 45 weist einen zweiten Versorgungsspannungsanschluss 46 auf, der über eine Leitung 47 an dem Knoten 34 anliegt. Der zweite Versorgungsspannungsanschluss 42 des Treibers 37 liegt ebenfalls über eine Versorgungsspannungsleitung 48 an dem Knoten 36 an. Die zweite Spannungsquelle 45 zur Erzeugung der zweiten Versorgungsspannung für den Treiber 37 ist, wie man der Figur 3 entnehmen kann, bezugspotentialfrei an den Ausgang 34 des Tiefpassfilters 30 angeschlossen. Die Amplitude der bezugspotentialfreien Versorgungsspannung $V_2$ der Versorgungsspannungsquelle 45 ist an die Signalamplituden der hochfrequenten Signalströme bzw. hochfrequenten Signale angepasst.

Die Versorgungsspannungsquelle 13 bewirkt am Signaleingang 38 des Treibers 37 eine konstante Signalpegelerhöhung um eine Spannung, die von der Versorgungsspannungsquelle 13 abgegeben wird. Die von der Versorgungsspannungsquelle 13 abgegebene Versorgungsspannung beträgt vorzugsweise die Hälfte der von der Versorgungsspannungsquelle 45 abgegebenen Versorgungsspannung $V_2$. Hierdurch ist es möglich den Treiber 37 innerhalb seines Versorgungsspannungsbereiches voll auszusteuern.

Der Ausgang 49 ist über eine Leitung 50 mit einem Ausgang 51 der Treiberschaltung 1 verbunden. An dem Ausgang 51 der Treiberschaltung 1 ist das Teilnehmergerät über Schutzschaltungen anschließbar. Die angeschlossenen Teilnehmerendgeräte und die Leitung zwischen der Treiberschaltung 1 und den Teilnehmerendgeräten weist einen komplexen Widerstand $Z_L$ auf.

Die Versorgungsspannung $V_1$ der ersten Versorgungsspannungsquelle 22 zur Spannungsversorgung des ersten Treibers 14 ergibt sich wie folgt:

$$V_1 = \hat{S}_1 + V_{Drop1}$$

wobei

$\hat{S}_1$ die Summe der Scheitelwerte des Gleichspannungssignals, des Ruftonsignals und gegebenenfalls des Sprachsignals ist,

$V_{Drop1}$ der konstruktionsbedingte Spannungsabfall in der Treiberschaltung 14 ist.

Die Versorgungsspannung $V_2$, die durch die zweite Versorgungsspannungsquelle 45 zur Spannungsversorgung des zweiten Treibers 37 abgegeben wird, ergibt sich wie folgt:

$$V_2 = \hat{S}_2 + V_{Drop2}$$

Wobei

$\hat{S}_2$ Scheitelwert der hochfrequenten Signalströme und gegebenenfalls des Sprachsignals ist,

$V_{Drop2}$ der konstruktionsbedingte Spannungsabfall in der Treiberschaltung 37 ist.

Daraus ergibt sich die laststrombedingte Verlustleistung der Gesamttreiberschaltung 1 aus:

$$P_V = P_G - P_L = P_{V1} + P_{V2} - P_L = V_1 \cdot F_1 \cdot i_1 + V_2 \cdot F_2 \cdot i_{1,2} - P_L$$

Wobei;

$P_V$    laststrombedingte Verlustleistung in der Gesamttreiberschaltung
$P_G$    laststrombedingte Gesamtleistungsaufnahme der Gesamttreiberschaltung
$P_L$    an die Last $Z_L$ abgegebene Leistung
$V_1$    Versorgungsspannung der Treiberschaltung 14
$V_2$    Versorgungsspannung der Treiberschaltung 37
$i_{1,2}$    Effektivwert des gesamten Signalstromes
$i_1$    Effektivwert des DC-Signalstromes und der niederfrequenten Signalströme
$F_1$    Formfaktor, d.h. das signalformabhängige Verhältnis zwischen Gleichrichtwert und Effektivwert des hochfrequenten Signals
$F_2$    Formfaktor, d.h. das signalformabhängige Verhältnis zwischen Gleichrichtwert und Effektivwert des Gesamtausgangssignals ist.

Die Verlustleitung der erfindungsgemäßen Treiberschaltung ist wie ein Vergleich der beiden Gleichungen 2,6 ergibt, wesentlich geringer als bei der herkömmlichen Treiberschaltung T wie sie in Figur 2 dargestellt ist.

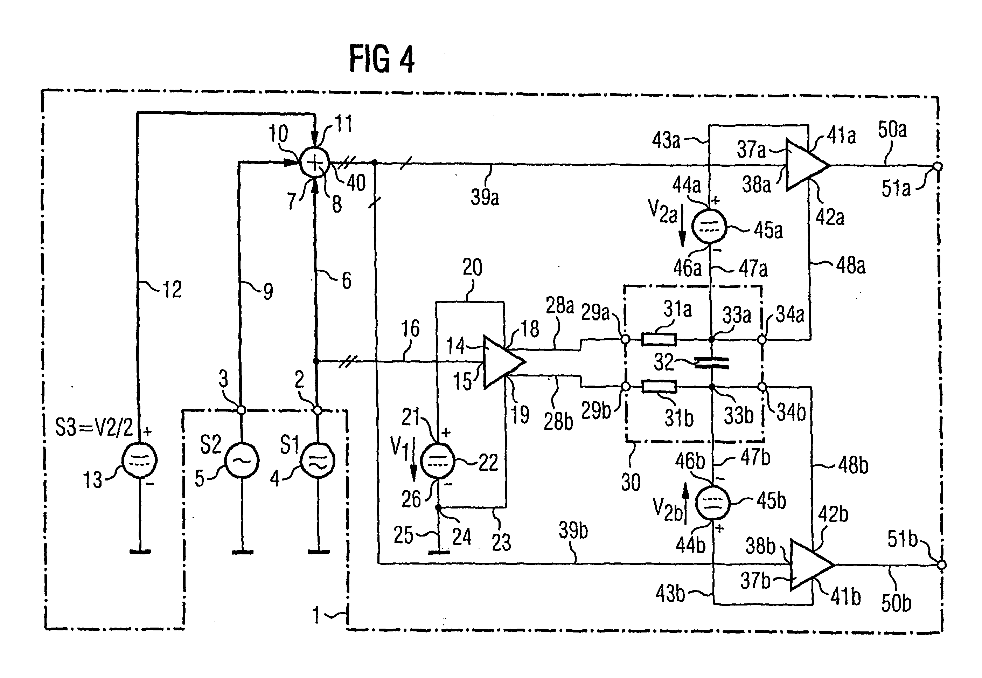

Figur 4 zeigt eine besonders bevorzugte Ausführungsform der erfindungsgemäßen Treiberschaltung 1. Die in Figur 4 gezeigte bevorzugte Ausführungsform der Treiberschaltung 1 ist differentiell aufgebaut. Dabei besteht der zweite Treiber 37 aus zwei differentiell zueinander verschalteten Operationsverstärkern 37a, 37b, die jeweils durch eine zugehörige bezugspotentialfreie Versorgungsspannung $V_{2a}$, $V_{2b}$ versorgt werden. Die beiden bezugspotentialfreien Versorgungsspannungen $V_{2a}$, $V_{2b}$ werden vorzugsweise jeweils durch Sperrwandler erzeugt, deren Sekundärwicklung nicht geerdet ist.

Die Verlustleistung der erfindungsgemäßen Treiberschaltung 1 ist im Vergleich zur herkömmlichen Treiberschaltung T, wie sie in Figur 2 dargestellt ist, sehr gering, wie folgendes Beispiel belegt.

Wird als niederfrequenter Stromanteil ein Ruftonsignal 65Vrms/20 Hz als hochfrequenter Signalstrom ein Full Rate ADSL-Signal mit 20 dBm Sendeleistung auf der Leitung angenommen, ergeben sich folgende Werte:

Spannungsscheitelwert $\hat{S}_1$ der niederfrequenten Signale $\hat{S}_1$ =110V;

Spannungsscheitelwert $\hat{S}_2$ der hochfrequenten Signale $\hat{S}_2$ = 35V;

Konstruktionsbedingter Spannungsabfall der Treiberschaltung T nach dem Stand der Technik $V_{Drop}$ = 15V;

Somit beträgt die Versorgungsspannung der Treiberschaltung T nach dem Stand der Technik:

$$V_B = \hat{S}_1 + \hat{S}_2 + V_{Drop} = 160V$$

$P_L$ = 950mW
$i_{1,2}$ = 32mA
$F_1$ = 0,85
$F_2$ = 0,9

Es ergibt sich die laststrombedingte Verlustleitung $P_V$ in der Treiberschaltung T nach dem Stand der Technik zu:

$$P_V = P_G - P_L = V_B \cdot F \cdot i_{1,2} - P_L = 160V - 0.85 \cdot 32mA - 950mW$$

$$= \underline{3.4W}$$

Dem gegenüber ergibt sich für die erfindungsgemäße Treiberschaltung 1, wie sie in Figur 4 dargestellt ist:
mit $S_1$ = 110V
     $V_{Drop1}$ = 10V
erhält man eine erste Versorgungsspannung für den ersten Treiber 14 von

$$V_1 = \hat{S}_1 + V_{Drop1} = 120V$$

mit $\hat{S}_2$ = 35V und
     $V_{Drop2}$ = 5V
ergibt sich die Versorgungsspannung für den zweiten Treiber

$$V_{2a}, V_{2b} = \overset{\wedge}{S}_2 + V_{Drop2} = 40V$$

mit $P_L$ = 950mW

$i_1$ = 11mA

$i_{1,2}$ = 32mA

$F_1$ = 0.85

$F_2$ = 0, 9

Die Verlustleistung $P_V$ der erfindungsgemäßen Treiberschaltung 1 ist somit:

$$P_V = P_G - P_L = P_{V1} + P_{V2} - P_L = V_1 \cdot F_1 \cdot i_1 + V_2 \cdot F_2 \cdot i_{1,2} - P_L$$

$$=$$

$$120V \cdot 0.85 \cdot 11mA + 40V \cdot 0.9 \cdot 32mA - 950mW = \underline{1.324W}$$

Die Verlustleistungseinsparung $\Delta P$ der erfindungsgemäßen Treiberschaltung 1, wie sie in Figur 4 dargestellt ist, gegenüber der herkömmlichen Treiberschaltung T, wie sie in Figur 2 dargestellt ist, beträgt demnach:

$$\Delta P = 3.4W - 1.324W = \underline{2,076W}$$

Durch die erfindungsgemäße Treiberschaltung 1 werden die Signalstromkreise frequenzmäßig auf zwei Signalfade aufgetrennt. Durch die neuartige Gestaltung des Versorgungsspannungskonzeptes, die eine frequenzmäßige Aufteilung der Signalstromfade vorsieht, können erhebliche Verlustleistungseinsparungen durch die erfindungsgemäße Treiberschaltung 1 erzielt werden. Bei herkömmlichen ADSL-Systemen werden die ADSL-Signale von speziellen Modems erzeugt und über aufwendige und kostenintensive Analogfilter bzw. Splitter in die Telefonleitung eingeschleift. Die Sprach- und Ruftonsignale werden von analogen sogenannten Linecards regeneriert. Durch den Splitter wird eine Parallelschaltung des Treibers für niederfrequente Signale aus der analogen Linecard und den Treibers für die hochfrequenten Signale aus dem ADSL-Modem ermöglicht. Die Trennung der beiden Signalstromfade erfolgt hierbei auf Signalebene. Hierdurch müssen die Splitter aus Analogfiltern mit sehr hohen Filterordnungen bestehen. Filter mit derartig hohen Filterordnungen sind nur sehr kostenintensiv herstellbar.

Demgegenüber erfolgt die Trennung der Signalstromfade bei der erfindungsgemäßen Treiberschaltung 1 auf der Versorgungsspannungsebene, wodurch der Einsatz eines sehr einfachen Tiefpassfilters 30 erster Ordnung genügt. Daher kann die erfindungsgemäße Treiberschaltung 1 mit einem sehr geringen Kostenaufwand hergestellt werden.

Die Verlustleistungsreduktion durch den erfindungsgemäßen schaltungstechnischen Aufbaue der Treiberschaltung 1 erlaubt es, die Treiberschaltung in ein einfaches Gehäuse mit sehr kleinen Kühlkörpern zu integrieren.

Die erfindungsgemäße Treiberschaltung 1 weist noch die folgenden weiteren Vorteile auf.

Der in der Treiberschaltung 37 fließende Ruhestrom ist aufgrund der notwendigen Frequenzbandbreite der Schaltung sehr hoch. Dieser Ruhestrom fließt nun ausschließlich über die Versorgungsspannung $V_2$, die viel geringer ist als die Versorgungsspannung $V_1$. Hierdurch wird eine weitere erhebliche Verlustleistungseinsparung gewährleistet.

Ein weiterer Vorteil besteht darin, dass für die niederfrequenten Signalströme in den ersten Treiber 14 nunmehr niedrigere Strombegrenzungswerte festgelegt werden können, als für den Gesamtsignalstrom in dem Treiber 37. Hierdurch ergibt sich eine höhere Überstromfestigkeit der erfindungsgemäßen Treiberschaltung 1.

Ein weiterer Vorteil besteht darin, dass aufgrund der wesentlich geringeren Versorgungsspannung $V_2$ für den zweiten Treiber 37, dieser Treiber 37 mit schnelleren Transistoren mit geringerer Spannungsfestigkeit aufgebaut werden kann. Hierdurch wird das Erreichen der notwendigen Breitbandigkeit wesentlich erleichtert.

Bezugszeichenliste:

1 Treiberschaltung

2 Signaleingang

3 Signaleingang

4 niederfrequente Signalquelle

5 hochfrequente Signalquelle

| | |
|---|---|
| 6 | Leitung |
| 7 | Summiereingang |
| 8 | Summierer |
| 9 | Leitung |
| 10 | Summiereingang |
| 11 | Summiereingang |
| 12 | Leitung |
| 13 | Spannungsquelle |
| 14 | erster Treiber |
| 15 | Treibereingang |
| 16 | Leitung |
| 17 | Verzweigungsknoten |
| 18 | Versorgungsspannungsanschluss |
| 19 | Versorgungsspannungsanschluss |
| 20 | Versorgungsspannungsleitung |
| 21 | Spannungsquellenanschluss |
| 22 | Spannungsquelle |
| 23 | Versorgungsspannungsleitung |
| 24 | Knoten |
| 25 | Leitung |
| 26 | Spannungsquellenanschluss |
| 27 | Treiberausgang |
| 28 | Leitung |
| 29 | Filtereingang |
| 30 | Tiefpassfilter |
| 31 | Widerstand |
| 32 | Kondensator |
| 33 | Knoten |
| 34 | Filterausgang |
| 35 | Leitung |
| 36 | Knoten |
| 37 | zweiter Treiber |
| 38 | Treibereingang |
| 39 | Leitung |
| 40 | Summiererausgang |
| 41 | Versorgungsspannungsanschluss |
| 42 | Versorgungsspannungsanschluss |
| 43 | Versorgungsspannungsleitung |
| 44 | Spannungsquellenanschluss |
| 45 | Spannungsquelle |
| 46 | Spannungsquellenanschluss |
| 47 | Leitung |
| 48 | Versorgungsspannungsleitung |
| 49 | Treiberausgang |
| 50 | Leitung |
| 51 | Treiberausgang |

**Patentansprüche**

1. Treiberschaltung für mindestens ein Teilnehmerendgerät mit:

   einem ersten Treiber (14) zur Leistungsverstärkung eines Gleichstromes zur Leistungsversorgung des Teilnehmerendgeräts, zur Leistungsverstärkung von Sprachsignalströmen und eines Ruftonstromes, wobei der erste Treiber (14) durch eine erste Versorgungsspannung ($V_1$) versorgt wird, und mit

   einem dem ersten Treiber (14) nachgeschaltetem zweiten Treiber (37; 37a, 37b) zum Aufmodulieren von hochfrequenten Datensignalströmen auf die durch den ersten Treiber (14) leistungsverstärkten Signalströme.

**2.** Treiberschaltung nach Anspruch 1,
**dadurch gekennzeichnet,**
**dass** dem ersten Treiber (14) ein Tiefpassfilter (30) nachgeschaltet ist.

**3.** Treiberschaltung nach einem der vorangehenden Ansprüche
**dadurch gekennzeichnet,**
**dass** das Tiefpassfilter (30) ein Tiefpassfilter erster Ordnung ist.

**4.** Treiberschaltung nach einem der vorangehenden Ansprüche
**dadurch gekennzeichnet,**
**dass** das Tiefpassfilter erster Ordnung ein RC-Tiefpassfilter ist mit einem Widerstand (31; 31a, 31b) und einem Kondensator (32) ist.

**5.** Treiberschaltung nach Anspruch 4,
**dadurch gekennzeichnet,**
**dass** der Widerstand (31; 31a, 31b) ein passives Bauelement ist.

**6.** Treiberschaltung nach Anspruch 4,
**dadurch gekennzeichnet,**
**dass** der Widerstand (31; 31a, 31b) ein aktive Impedanz ist.

**7.** Treiberschaltung nach einem der vorangehenden Ansprüche
**dadurch gekennzeichnet,**
**dass** die Grenzfrequenz $f_G$ des Tiefpassfilters (30) einstellbar ist.

**8.** Treiberschaltung nach einem der vorangehenden Ansprüche
**dadurch gekennzeichnet,**
**dass** die Grenzfrequenz $f_G$ des Tiefpassfilters (30) zwischen der oberen Grenzfrequenz der niederfrequenten Signalströme und der unteren Grenzfrequenz der hochfrequenten Signalströme liegt.

**9.** Treiberschaltung nach einem der vorangehenden Ansprüche
**dadurch gekennzeichnet,**
**dass** eine erste Spannungsquelle (22) zur Erzeugung der ersten Spannungs ($V_1$) vorgesehen ist, die ein festes Bezugspotential aufweist.

**10.** Treiberschaltung nach einem der vorangehenden Ansprüche
**dadurch gekennzeichnet,**
**dass** eine zweite Spannungsquelle (45; 45a, 45b) zu Erzeugung der zweiten Versorgungsspannung ($V_2$; $V_{2a}$, $V_{2b}$) vorgesehen ist, die bezugspotentialfrei an einem Ausgang (34; 34a, 34b) des Tiefpassfilters (30) angeschlossen ist.

**11.** Treiberschaltung nach einem der vorangehenden Ansprüche
**dadurch gekennzeichnet,**
**dass** die von der zweiten Spannungsquelle (45; 45a, 45b) abgegebene zweite Versorgungsspannung ($V_2$; $V_{2a}$, $V_{2b}$) für den zweiten Treiber (37; 37a, 37b) wesentlich niedriger ist als die von der ersten Spannungsquelle (22) abgegebene erste Versorgungsspannung ($V_1$) für den ersten Treiber (14).

**12.** Treiberschaltung nach einem der vorangehenden Ansprüche
**dadurch gekennzeichnet,**
**dass** der erste Treiber (14) ein Operationsverstärker ist.

**13.** Treiberschaltung nach einem der vorangehenden Ansprüche 1 bis 11,
**dadurch gekennzeichnet,**
**dass** der erste Treiber (14) ein DC/DC-Wandler mit Stromrückspeisung ist.

**14.** Treiberschaltung nach einem der vorangehenden Ansprüche 1 bis 8,
**dadurch gekennzeichnet,**
**dass** der erste Treiber (14) ein AC/DC-Wandler mit Stromrückspeisung ist.

**15.** Treiberschaltung nach einem der vorangehenden Ansprüche
**dadurch gekennzeichnet,**
**dass** der zweite Treiber (37) ein Operationsverstärker ist.

**16.** Treiberschaltung nach einem der vorangehenden Ansprüche
**dadurch gekennzeichnet,**
**dass** an einen Signaleingang (15) des ersten Treibers (14) eine niederfrequente Signalquelle (4) anschließbar ist.

**17.** Treiberschaltung nach einem der vorangehenden Ansprüche
**dadurch gekennzeichnet,**
**dass** an einen Signaleingang (38) des zweiten Treibers (37) ein Ausgang (40) einer Summierschaltung (8) angeschlossen ist.

**18.** Treiberschaltung nach einem der vorangehenden Ansprüche
**dadurch gekennzeichnet,**
**dass** die niederfrequente Signalquelle (4) an einen ersten Eingang (7) der Summierschaltung (8) anschließbar ist.

**19.** Treiberschaltung nach einem der vorangehenden Ansprüche
**dadurch gekennzeichnet,**
**dass** die hochfrequente Signalquelle (5) an einen zweiten Eingang (10) der Summierschaltung (8) anschließbar ist.

**20.** Treiberschaltung nach einem der vorangehenden Ansprüche
**dadurch gekennzeichnet,**
**dass** an einen dritten Eingang (11) der Summierschaltung (8) eine dritte Versorgungsspannungsquelle (13) angeschlossen ist zur Signalpegelerhöhung an dem Signaleingang (38) des zweiten Treibers (37).

**21.** Treiberschaltung nach einem der vorangehenden Ansprüche
**dadurch gekennzeichnet,**
**dass** die dritte Versorgungsspannungsquelle (13) eine Versorgungsspannung ($V_3$) abgibt, die halb so hoch ist wie die zweite Versorgungsspannung ($V_2$).

**22.** Treiberschaltung nach einem der vorangehenden Ansprüche
**dadurch gekennzeichnet,**
**dass** an einem Signalausgang (49) des zweiten Treibers (37) das Teilnehmerendgerät anschließbar ist.

**23.** Treiberschaltung nach einem der vorangehenden Ansprüche
**dadurch gekennzeichnet,**
**dass** die Datensignalströme xDSL-Datensignalströme sind.

**24.** Treiberschaltung nach einem der vorangehenden Ansprüche
**dadurch gekennzeichnet,**
**dass** die Treiberschaltung (1) differentiell aufgebaut ist.

**25.** Treiberschaltung nach Anspruch 34,
**dadurch gekennzeichnet,**
**dass** der zweite Treiber (37) aus zwei differentiell zueinander verschalteten Operationsverstärkern (37a, 37b) besteht, die jeweils durch eine bezugspotentialfreie Versorgungsspannung ($V_{2a}$, $V_{2b}$) versorgt werden.

**26.** Treiberschaltung nach Anspruch 25,
**dadurch gekennzeichnet,**
**dass** die beiden bezugspotentialfreien Versorgungsspannungen ($V_{2a}$, $V_{2b}$) jeweils durch einen Sperrwandler erzeugt werden, dessen Sekundärwicklung nicht geerdet ist.

**Claims**

**1.** Driver circuit for at least one subscriber terminal, comprising:

a first driver (14) for amplifying the power of a direct current for supplying power to the subscriber terminal, for amplifying the power of voice signal currents and of a ringing tone current, the first driver (14) being supplied by a first supply voltage ($V_1$), and comprising

a second driver (37; 37a, 37b) following the first driver (14) for modulating high-frequency data signal currents onto the signal currents power-amplified by the first driver (14).

2. Driver circuit according to Claim 1, **characterized in that** the first driver (14) is followed by a low-pass filter (30).

3. Driver circuit according to one of the preceding claims, **characterized in that** the low-pass filter (30) is a first-order low-pass filter.

4. Driver circuit according to one of the preceding claims, **characterized in that** the first-order low-pass filter is an RC low-pass filter with a resistor (31; 31a, 31b) and a capacitor (32).

5. Driver circuit according to Claim 4, **characterized in that** the resistor (31; 31a, 31b) is a passive component.

6. Driver circuit according to Claim 4, **characterized in that** the resistor (31; 31a, 31b) is an active impedance.

7. Driver circuit according to one of the preceding claims, **characterized in that** the cut-off frequency $f_G$ of the low-pass filter (30) can be adjusted.

8. Driver circuit according to one of the preceding claims, **characterized in that** the cut-off frequency $f_G$ of the low-pass filter (30) is between the upper cut-off frequency of the low-frequency signal currents and the lower cut-off frequency of the high-frequency signal currents.

9. Driver circuit according to one of the preceding claims, **characterized in that** a first voltage source (22) is provided for generating the first voltage ($V_1$) which has a fixed reference potential.

10. Driver circuit according to one of the preceding claims, **characterized in that** a second voltage source (45; 45a, 45b) for generating the second supply voltage ($V_2$; $V_{2a}$, $V_{2b}$) is provided which is connected free of reference potential to an output (34; 34a, 34b) of the low-pass filter (30).

11. Driver circuit according to one of the preceding claims, **characterized in that** the second supply voltage ($V_2$; $V_{2a}$, $V_{2b}$) for the second driver (37; 37a, 37b), delivered by the second voltage source (45; 45a, 45b), is much lower than the first supply voltage ($V_1$) for the first driver (14), delivered by the first voltage source (22).

12. Driver circuit according to one of the preceding claims, **characterized in that** the first driver (14) is an operational amplifier.

13. Driver circuit according to one of the preceding Claims 1 to 11, **characterized in that** the first driver (14) is a DC/DC converter with current feedback.

14. Driver circuit according to one of the preceding Claims 1 to 8, **characterized in that** the first driver (14) is an AC/DC converter with current feedback.

15. Driver circuit according to one of the preceding claims, **characterized in that** the second driver (37) is an operational amplifier.

16. Driver circuit according to one of the preceding claims, **characterized in that** a low-frequency signal source (4) can be connected to a signal input (15) of the first driver (14).

17. Driver circuit according to one of the preceding claims, **characterized in that** an output (40) of a summing circuit (8) is connected to a signal input (38) of the second driver (37).

18. Driver circuit according to one of the preceding claims, **characterized in that** the low-frequency signal source (4) can be connected to a first input (7) of the summing circuit (8).

**19.** Driver circuit according to one of the preceding claims, **characterized in that** the high-frequency signal source (5) can be connected to a second input (10) of the summing circuit (8).

**20.** Driver circuit according to one of the preceding claims, **characterized in that** a third supply voltage source (13) is connected to a third input (11) of the summing circuit (8) to increase the signal level at the signal input (38) of the second driver (37).

**21.** Driver circuit according to one of the preceding claims, **characterized in that** the third supply voltage source (13) delivers a supply voltage ($V_3$) which has half the amplitude of the second supply voltage ($V_2$).

**22.** Driver circuit according to one of the preceding claims, **characterized in that** the subscriber terminal can be connected to a signal output (49) of the second driver (37).

**23.** Driver circuit according to one of the preceding claims, **characterized in that** the data signal currents are xDSL data signal currents.

**24.** Driver circuit according to one of the preceding claims, **characterized in that** the driver circuit (1) is of differential construction.

**25.** Driver circuit according to Claim 34, **characterized in that** the second driver (37) consists of two differentially interconnected operational amplifiers (37a, 37b) which are in each case supplied by a supply voltage ($V_{2a}$, $V_{2b}$) free of reference potential.

**26.** Driver circuit according to Claim 25, **characterized in that** the two supply voltages ($V_{2a}$, $V_{2b}$) free of reference potential are in each case generated by a flyback converter, the secondary winding of which is not earthed.

**Revendications**

**1.** Circuit d'attaque pour au moins un terminal d'abonné, comportant:

un premier étage d'attaque (14) pour réaliser une amplification de puissance de courant continu pour l'alimentation en puissance du terminal d'abonné, pour l'amplification de puissance de courant de signaux vocaux et d'un courant de tonalité d'appel, le premier étage d'attaque (14) étant alimenté par une première tension d'alimentation ($V_1$), et comportant
un second étage d'attaque (37; 37a, 37b), qui est branché en aval du premier étage d'attaque (14) et sert à moduler des courants de signaux dont la puissance est accrue par le premier étage d'attaque (14), par des courants de signaux de données à haute fréquence.

**2.** Circuit d'attaque selon la revendication 1, **caractérisé en ce qu'**un filtre passe-bas (30) est branché en aval du premier étage (14).

**3.** Circuit d'attaque selon l'une des revendications précédentes, **caractérisé en ce que** le filtre passe-bas (30) est un filtre passe-bas du premier ordre.

**4.** Circuit d'attaque selon l'une des revendications précédentes, **caractérisé en ce que** le filtre passe-bas du premier ordre est un filtre passe-bas RC comportant une résistance (31; 31a, 31b) et un condensateur (32).

**5.** Circuit d'attaque selon la revendication 4, **caractérisé en ce que** la résistance (31; 31a, 31b) est un composant passif.

**6.** Circuit d'attaque selon la revendication 4, **caractérisé en ce que** la résistance (31; 31a, 31b) est une impédance active.

**7.** Circuit d'attaque selon l'une des revendications précédentes, **caractérisé en ce que** la fréquence limite $f_G$ du filtre passe-bas (30) est réglable.

**8.** Circuit d'attaque selon l'une des revendications précédentes, **caractérisé en ce que** la fréquence limite $f_G$ du filtre passe-bas (30) est située entre la fréquence limite supérieure des courants de signaux à basse fréquence et la fréquence limite inférieure des courants de signaux à haute fréquence.

9. Circuit d'attaque selon l'une des revendications précédentes, **caractérisé en ce qu'**il est prévu une première source de tension (22) pour produire la première tension ($V_1$), qui possède un premier potentiel de référence.

10. Circuit d'attaque selon l'une des revendications précédentes, **caractérisé en ce qu'**une seconde source de tension (45; 45a, 45b) est prévue pour la production de la seconde tension d'alimentation ($V_2$; $V_{2a}$, $V_{2b}$), qui est raccordée à un potentiel de référence, à une sortie (34; 34a, 34b) du filtre passe-bas (30).

11. Circuit d'attaque selon l'une des revendications précédentes, **caractérisé en ce qu'**une seconde tension d'alimentation ($V_2$; $V_{2a}$, $V_{2b}$) délivrée par la seconde source de tension (45; 45a, 45b) pour le second étage d'attaque (37; 37a, 37b) est nettement inférieure à la première tension d'alimentation ($V_1$), délivrée par la première source de tension (22), pour le premier étage d'attaque (16).

12. Circuit d'attaque selon l'une des revendications précédentes, **caractérisé en ce que** le premier étage d'attaque (14) est un amplificateur opérationnel.

13. Circuit d'attaque selon l'une des revendications précédentes 1 à 11, **caractérisé en ce que** le premier étage d'attaque (14) est un convertisseur continu-continu comportant une alimentation en retour de courant.

14. Circuit d'attaque selon l'une des revendications précédentes 1 à 8, **caractérisé en ce que** le premier étage d'attaque (14) est un convertisseur alternatif-continu comportant une alimentation en retour de courant.

15. Circuit d'attaque selon l'une des revendications précédentes, **caractérisé en ce que** le second étage d'attaque (37) est un amplificateur opérationnel.

16. Circuit d'attaque selon l'une des revendications précédentes, **caractérisé en ce qu'**une source de signaux à basse fréquence (4) peut être raccordée à une entrée de signal (15) du premier étage d'attaque (14).

17. Circuit d'attaque selon l'une des revendications précédentes, **caractérisé en ce qu'**une sortie (40)du circuit de sommation (8) est raccordée à une entrée de signal (38) du second étage d'attaque (37).

18. Circuit d'attaque selon l'une des revendications précédentes, **caractérisé en ce que** la source de signaux à basse fréquence (4) peut être raccordée à une première entrée (7) du circuit de sommation (8).

19. Circuit d'attaque selon l'une des revendications précédentes, **caractérisé en ce que** la source de signaux à haute fréquence (5) peut être raccordée à une seconde entrée (10) du circuit de sommation (8).

20. Circuit d'attaque selon l'une des revendications précédentes, **caractérisé en ce qu'**à une troisième entrée (11) du circuit de sommation (8) est raccordée une troisième source de tension d'alimentation (13) servant à accroître le niveau du signal à l'entrée de signal (38) du second étage d'attaque (37).

21. Circuit d'attaque selon l'une des revendications précédentes, **caractérisé en ce que** la troisième source de tension d'alimentation (13) délivre une tension d'alimentation ($V_3$) qui est égale à la moitié de la seconde tension d'alimentation ($V_2$).

22. Circuit d'attaque selon l'une des revendications précédentes, **caractérisé en ce que** le terminal d'abonné peut être raccordé à une sortie de signal (49) du second étage d'attaque (37).

23. Circuit d'attaque selon l'une des revendications précédentes, **caractérisé en ce que** les flux de signaux de données sont des flux de signaux de données xDSL.

24. Circuit d'attaque selon l'une des revendications précédentes, **caractérisé en ce que** le circuit d'attaque (1) est agencé en tant que circuit différentiel.

25. Circuit d'attaque selon la revendication 34, **caractérisé en ce que** le second étage d'attaque (37) est constitué par deux amplificateurs opérationnels (37a, 37b) branchés d'une manière différentielle l'un par rapport à l'autre et qui sont alimentés chacun par une tension d'alimentation ($V_{2a}$, $V_{2b}$) sans potentiel de référence.

26. Circuit d'attaque selon la revendication 25, **caractérisé en ce que** les deux tensions d'alimentation ($V_{2a}$, $V_{2b}$) sans potentiel de référence sont produites respectivement par un convertisseur à oscillateur bloqué, dont l'enroulement secondaire n'est pas mis à la masse.

## FIG 1 Stand der Technik

## FIG 2
Stand der Technik

FIG 3

FIG 4